# EUROPEAN PATENT SPECIFICATION

(11) **EP 3 661 685 B1**
(45) Date of publication and mention of the grant of the patent: **26.06.2024**
(21) Application number: 18752450.9
(22) Date of filing: 06.08.2018
(51) Int. Cl.: C23C 14/06, C23C 14/35, C23C 14/34, C23C 28/04, B23G 5/00, B23G 5/06

(54) **TAP DRILL WITH ENHANCED PERFORMANCE**
GEWINDEBOHRER MIT VERBESSERTER LEISTUNG
TARAUD À PERFORMANCES AMÉLIORÉES

(30) Priority: 04.08.2017 US 201762541195 P
(43) Date of publication of application: 10.06.2020
(73) Proprietor: Oerlikon Surface Solutions AG, Pfäffikon, 8808 Pfäffikon SZ (CH)
(72) Inventor: KURAPOV, Denis, 8880 Walenstadt (CH)
(74) Representative: Misselhorn, Hein-Martin
(86) International application number: PCT/EP2018/071255
(87) International publication number: WO 2019/025629

(56) References cited:
- EP-A1- 1 726 390
- EP-A1- 2 835 200
- WO-A1-2009/074343
- US-A1- 2005 003 239
- US-A1- 2010 260 566
- US-A1- 2014 248 100
- US-A1- 2016 068 449
- US-B2- 7 348 074
- US-B2- 7 901 796

## Description

The present invention relates to a tap drill with enhanced performance, comprising a wear resistance layer of Al-Cr-N and a friction reduction layer deposited atop the wear resistance layer and to a method for producing a tap drill.

### State of the art

In the document US 9540726 B2 it is proposed to improve performance of drills, in particular of tap drills and micro drills by coating at least the head of the drill. The coating comprises at least one HiPIMS coating that is applied directly onto the drill substrate and which includes at least one layer of at least one nitride and/or carbide and/or oxide, and an amorphous carbon or DLC layer provided on the HiPIMS layer. The HiPIMS coating can be a (AI,Cr)N layer and the DLC layer can be a metalliferous DLC layer. The drill shown in US 9540726 B2 can be used in drilling operations of stainless steel workpieces, however the tool life is relatively short.

EP 1 726 390 A1 describes a surface-coated cutting tool which includes a base material on which formed an inner layer composed of a compound containing Al, at least one of elements Cr and V and at least one element selected from the group consisting of nitrogen, carbon and oxygen, and an outermost layer composed of a carbonitride of TiSi is further formed on the inner layer. The surface-coated cutting tool is appropriately used for such tools as drill, end mill, throwaway tips for milling and turning, metal saw, gear cutting tool, reamer, and tap. The surface-coated cutting tool improved in peeling resistance and wear resistance as compared with conventional tools can thus be provided.

US 2005/003239 A1 describes a work piece or structural component which is coated with a system of film layers at least one of which is composed of (AlyCr1-y) X, where X=N, C, B, CN, BN, CBN, NO, CO, BO, CNO, BNO or CBNO and 0.2<=y<0.7, with the composition within said film being either essentially constant or varying over the thickness of the film continually or in steps, as well as a process for producing it.

US 2014/248100 A1 relates to a method for coating a substrate, preferably a drill, wherein at least one first HiPIMS layer is applied by means of a HiPIMS process. Preferably, at least one second layer is applied to the first HiPIMS layer by means of a coating process that does not contain a HiPIMS process.

### Objective of the present invention

The objective of the present invention is to provide a coated tap drill and a method for producing a tap drill that may exhibit better performance and relative tool life in drilling operations of stainless steel workpieces in comparison with the state of the art. In particular, better performance in relation to friction reduction and cold-welding reduction properties.

### Description of the present invention

The invention is defined by the appended claims.

The objective of the present invention is attained by providing a tap drill comprising a substrate and a coating, wherein the coating is deposited on at least a portion of the substrate comprising the head of the drill, the coating comprising a first layer deposited directly on the substrate and a second layer deposited atop the first layer, wherein the first layer is a wear resistant layer of (AI,Cr)N deposited by HiPIMS and the second layer is a friction reduction layer, characterized in that:
- The second layer (5) is a titanium carbide layer deposited by using a physical vapor deposition (PVD) process of the type magnetron sputtering.

HiPIMS methods are also known as HPPMS methods because of the terminology high power pulsed magnetron sputtering.

Coatings produced by sputtering, in particular by HiPIMS show much better performance compared to coatings produced by arc, in particular if arc-deposited coating is without post-treatment.

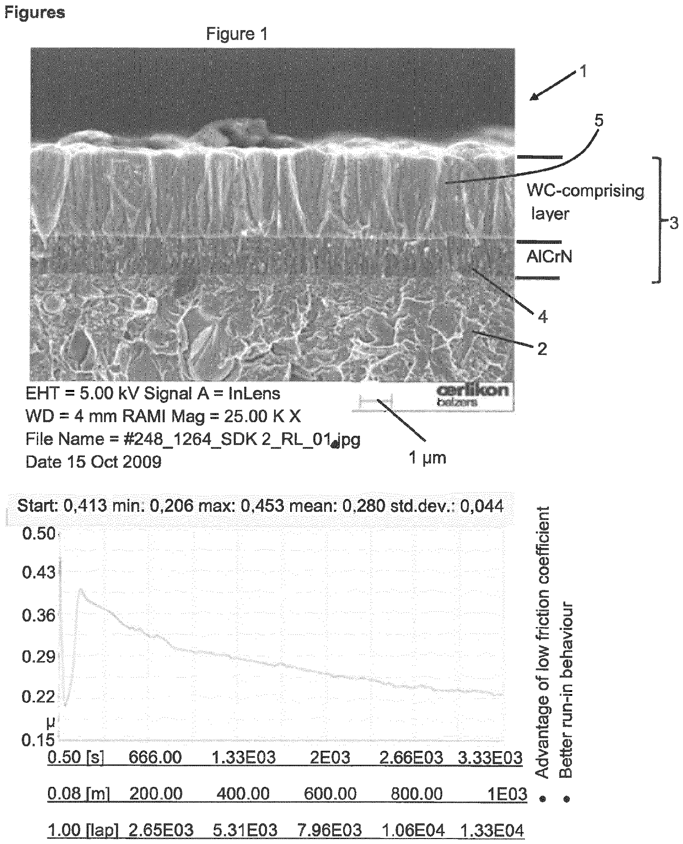

HiPIMS provides the possibility to produce dense and smooth coatings. The non-inventive AICrN+WC/C coating shown in figure 1 can be produced in one deposition run.

The non-inventive friction reduction layer is carbon-containing titanium nitride or titan carbonitride or diamond like carbon doped with tungsten carbide or a tungsten carbide layer.

According to the present invention the metal carbide layer is a titanium carbide layer.

The objective of the present invention is attained by providing a method for producing a tap drill according to claim 3.

According to the invention the second layer is a titanium carbide comprising layer and is deposited by sputtering of Ti orTiC targets in an atmosphere comprising argon and a carbon-containing gas, preferably acetylene gas.

HiPIMS techniques are used for sputtering of the Ti of TiC targets.

Figure 1 shows a non-inventive coating for tap drill.

Figure 2 shows the tool life for different coatings.

Figure 1 shows in the upper part a picture of a non-inventive tap drill.

The tap drill 1 comprises a substrate 2 and a coating 3. The coating 3 is deposited on at least a portion of the substrate 2 comprising the head of the drill 1.

The coating 3 comprises a first layer 4. The first layer 4 is deposited directly on the substrate 2. The coating 3 comprises a second layer 5. The second layer 5 is deposited atop the first layer 4.

The first layer 4 is a wear resistant layer of (AI,Cr)N. The first layer 4 is deposited by HiPIMS. The second layer 5 is a friction reducing layer. The second layer 5 is a metal carbide layer or a metal-carbide comprising layer. It can also be preferably of carbon-containing titanium nitride or titan carbonitride or diamond like carbon doped with tungsten or a tungsten carbide layer. The second layer 5 is deposited using physical a vapor deposition (PVD) process, preferably of the type magnetron sputtering, preferably of the type HiPIMS.

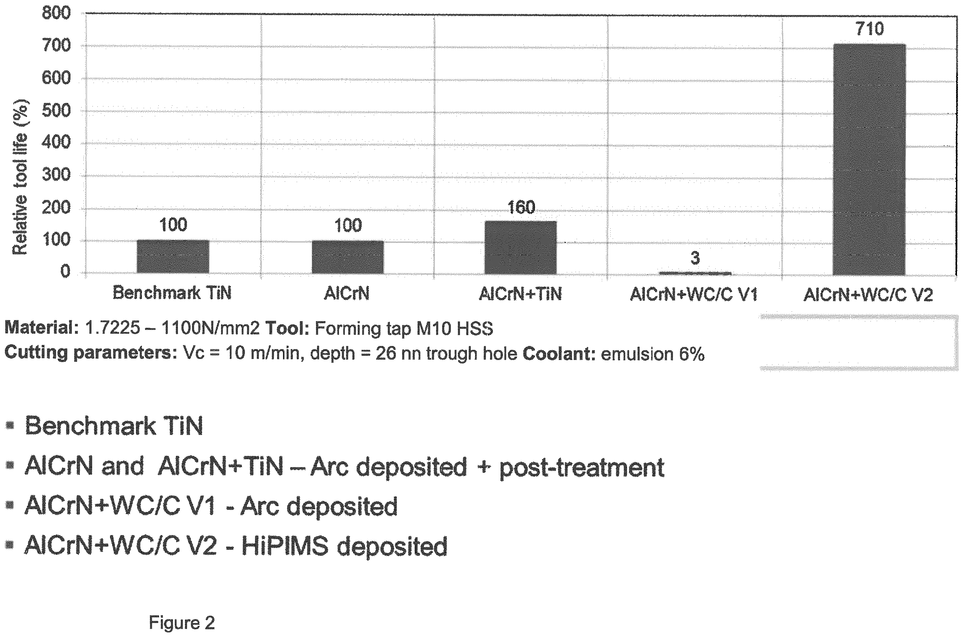

This can be seen in figure 2, which shows in a diagram the relative tool life of different coatings and/or depositing methods. The tool life of the Benchmark tool is defined to 100 %. In figure 2 the Benchmark tool has been deposited with TiN. An AlCrN coating shows the same tool life of 100 % compared to the Benchmark. An AlCrN + TiN coating, which has been deposited by Arc deposition and post-treated in order to reduce roughness shows a tool life of 160 % compared to the Benchmark. A significant tool life increase can be seen. An AlCrN + WC/C coating that has been deposited by Arc deposition shows a tool life of 3 % compared to the Benchmark. An AlCrN + WC/C coating deposited by HiPIMS deposition shows a tool life of 710 % compared to the Benchmark.

AICrN+TiN coating (deposited by arc plus post-treatment in order to reduce roughness) show significant tool life increase vs. Benchmark.

Smooth coating surface has advantage.

Coatings produced by sputtering, in particular by HiPIMS show much better performance compared to coatings produced by arc, in particular if arc-deposited coating is without post-treatment.

HiPIMS provides the possibility to produce dense and smooth coatings. Coating like the AICrN+WC/C coating shown in figure 1 can be produced in one deposition run.
▪ AICrN+Ti(CN) coating shows increase in the tool life.

Preferably the first layer 4 is deposited by sputtering of Cr targets in a nitrogen reactive atmosphere (comprising argon and nitrogen or only nitrogen) by using HiPIMS techniques.

According to the present invention, the second layer 5 is a titanium carbide comprising layer which can be deposited by sputtering of Ti or TiC targets in an atmosphere comprising argon and a carbon-containing gas, preferably acetylene gas (i.e. preferably in an atmosphere comprising argon and acetylene gas). According to a variant of this preferred embodiment instead of conventional sputtering techniques HiPIMS techniques are used for sputtering of the Ti or TiC targets.

## Claims

1. A tap drill (1) comprising a substrate (2) and a coating (3), wherein the coating (3) is deposited on at least a portion of the substrate (2) comprising the head of the drill, the coating (3) comprising a first layer (4) deposited directly on the substrate (2) and a second layer (5) deposited atop the first layer (4), wherein the first layer (4) is a wear resistant layer of (AI,Cr)N deposited by HiPIMS and the second layer (5) is a friction reduction layer, **characterized in that**
the second layer (5) is a titanium carbide layer deposited by using a physical vapor deposition (PVD) process of the type magnetron sputtering.

2. The tap drill according to claim 1, **characterized in that** the second layer (5) is deposited by using HiPIMS.

3. A method for producing a tap drill (1) comprising a substrate (2) and a coating (3), wherein the coating (3) is deposited on at least a portion of the substrate (2) comprising the head of the drill, the coating (3) comprising a first layer (4) and a second layer (5),
• wherein the first layer (4) is a wear resistant layer of (AlCr)N and deposited directly on the substrate (2) by HiPIMS, and wherein
• the second layer (5) is a friction reduction layer of the type titanium carbide layer deposited using a physical vapor deposition (PVD) process of the type magnetron sputtering.

4. The method according to claim 3, **characterized in that** the magnetron sputtering process for deposition of the titanium carbide layer is of the type HiPIMS.

5. The method according to claim 3 or 4, **characterized in that** the second layer (5) is a titanium carbide layer deposited by sputtering of Ti or TiC targets in an atmosphere comprising argon and a carbon-containing gas, preferably acetylene gas.

## Patentansprüche

1. Ein Gewindebohrer (1), umfassend ein Substrat (2) und eine Beschichtung (3), wobei die Beschichtung (3) auf zumindest einem Teil des Substrats (2) aufgetragen ist das den Kopf des Bohrers umfasst, wobei die Beschichtung (3) eine erste Schicht (4) umfasst, die direkt auf dem Substrat (2) aufgetragen ist, und eine zweite Schicht (5), die auf der ersten Schicht (4) aufgetragen ist, wobei die erste Schicht (4) eine verschleißfeste Schicht aus (Al,Cr)N ist, die mittels HiPIMS aufgetragen wird, und die zweite Schicht (5) eine Reibungsreduzierungsschicht ist, **gekennzeichnet dadurch, dass** die zweite Schicht (5) eine Titancarbidschicht ist, die durch Verwendung eines physikalischen Abscheideverfahrens aus der Gasphase (PVD) vom Typ Magnetron-Sputtern aufgetragen wird.

2. Der Gewindebohrer nach Anspruch 1, **gekennzeichnet dadurch, dass** die zweite Schicht (5) mittels HiPIMS aufgetragen wird.

3. Ein Verfahren zur Herstellung eines Gewindebohrers (1), umfassend ein Substrat (2) und eine Beschichtung (3), wobei die Beschichtung (3) auf zumindest einem Teil des Substrats (2) aufgetragen ist das den Kopf des Bohrers umfasst, wobei die Beschichtung (3) eine erste Schicht (4) und eine zweite Schicht (5) umfasst,
• wobei die erste Schicht (4) eine verschleißfeste Schicht aus (AlCr)N ist und direkt auf dem Substrat (2) mittels HiPIMS aufgetragen wird, und wobei
• die zweite Schicht (5) eine Reibungsreduzierungsschicht vom Typ Titancarbidschicht ist, die unter Verwendung eines physikalischen Abscheideverfahrens aus der Gasphase (PVD) vom Typ Magnetron-Sputtern aufgetragen wird.

4. Das Verfahren nach Anspruch 3, **gekennzeichnet dadurch, dass** das Magnetron-Sputterverfahren zur Aufbringung der Titancarbidschicht vom Typ HiPIMS ist.

5. Das Verfahren nach Anspruch 3 oder 4, **gekennzeichnet dadurch, dass** die zweite Schicht (5) eine Titancarbidschicht ist, die durch Sputtern von Ti- oder TiC-Z in einer Atmosphäre, die Argon und ein kohlenstoffhaltiges Gas, vorzugsweise Acetylen, umfasst, aufgetragen wird.

## Revendications

1. Un foret à tarauder (1) comprenant un substrat (2) et un revêtement (3), le revêtement (3) étant déposé sur au moins une partie du substrat (2) comprenant la tête du foret, le revêtement (3) comprenant une première couche (4) déposée directement sur le substrat (2) et une deuxième couche (5) déposée au-dessus de la première couche (4), la première couche (4) étant une couche de (AI,Cr)N résistante à l'usure déposée par HiPIMS et la deuxième couche (5) étant une couche de réduction de friction, **caractérisée en ce que** la deuxième couche (5) est une couche de carbure de titane déposée en utilisant un processus de dépôt physique en phase vapeur (PVD) du type pulvérisation magnétron.

2. Le foret à tarauder selon la revendication 1, **caractérisé en ce que** la deuxième couche (5) est déposée en utilisant HiPIMS.

3. Un procédé de fabrication d'un foret à tarauder (1) comprenant un substrat (2) et un revêtement (3), le revêtement (3) étant déposé sur au moins une partie du substrat (2) comprenant la tête du foret, le revêtement (3) comprenant une première couche (4) et une deuxième couche (5),
• où la première couche (4) est une couche de (AlCr)N résistante à l'usure et déposée directement sur le substrat (2) par HiPIMS, et où
• la deuxième couche (5) est une couche de réduction de friction du type couche de carbure de titane déposée en utilisant un processus de dépôt physique en phase vapeur (PVD) du type pulvérisation magnétron.

4. Le procédé selon la revendication 3, **caractérisé en ce que** le processus de pulvérisation magnétron pour le dépôt de la couche de carbure de titane est du type HiPIMS.

5. Le procédé selon la revendication 3 ou 4, **caractérisé en ce que** la deuxième couche (5) est une couche de carbure de titane déposée par pulvérisation de cibles de Ti ou TiC dans une atmosphère comprenant de l'argon et un gaz contenant du carbone, de préférence du gaz d'acétylène.
